# EUROPEAN PATENT APPLICATION

(11) **EP 2 172 991 A1**
(43) Date of publication of application: **07.04.2010**
(21) Application number: 08305638.2
(22) Date of filing: 03.10.2008
(51) Int. Cl.: H01L 51/52

(54) **OLED with a composite semi-transparent electrode to enhance light-extraction over a large range of wavelengths**

(71) Applicant: Thomson Licensing, Inc., 92100 Boulogne-Billancourt (FR)
(72) Inventor: Michellys, Jean-Yves, 04300 Forcalquier (FR)
(74) Representative: Ruellan-Lemonnier, Brigitte

(57) **Abstract**

dielectric material is selected in the group consisting of ZnSe, ZnS, SnS, TeO2 and TiO2
6. Organic light emitting diode according to any one of the preceding claims, **characterized in that** said interval between electrodes is an optical cavity.
7. Lighting or display panel comprising a plurality of organic light emitting diodes according to any one of the preceding claims.

## Description

One 4 of the electrodes 2, 4 of the OLED, which is semi-transparent comprises a stack of directly adjacent layers: a first metal layer 41, a first dielectric layer 42 having a thickness H_{D1} and an index of refraction n_{D1}, a second metal layer 43 and a second dielectric layer 44 having a thickness H_{D2} and an index of refraction n_{D2}. According to the invention : 0.8 x (λ_{M}/8.n_{D2}) < H_{D2} < 2.2 x (λ_{M}/8.n_{D2}) and (λ_{M}/8.n_{D1}) < H_{D1} < 4 x (λ_{M}/8.n_{D1}), where λ_{M} is central wavelength of emission.

Thank to the invention, the extraction of the emitted light is improved over a range of wavelength larger than 150 nm and the emission spectrum can be easily shaped.

The invention relates to an organic light emitting diode (OLED) comprising, between a bottom electrode and a top electrode, at least one organic layer that is able to emit light through one of these electrodes when an electric current is injected through this organic layer by said electrodes. The electrode though which this OLED can emit light should then be semi-transparent, i.e. transparent enough to let the emitted light escape from the OLED.

In order to improve light extraction emitted by the organic light-emitting layer through this semi-transparent electrode, it is a known technique (See EP1401034), in the OLED structures, to use an optical cavity effect between the bottom electrode and the top electrode, as soon as these electrodes are at least partially reflective: if λ_{E} is the emitted wavelength, if n_{O} is the optical index of the organic material between the electrodes, by properly choosing the distance between these two electrodes around λ_{E}/2.n_{O} possibly corrected with the penetration of light inside the electrodes, light extraction is improved. Generally, one of the electrodes is totally reflective and made of relatively thick layer of metal as Al or Ag, and the other electrode is semi-transparent and semi-reflective, and made of relatively thin (ex.: between 5 and 35 nm) layer of metal.

In order to still improve light extraction from the OLED, it is also a known technique to cover the thin metal layer by a dielectric layer of high index with a thickness of about λ_{E}/4.n_{D'} where n_{D} is the optical index of the dielectric material that is generally superior to 1.8. Such a dielectric layer is then a light-extraction enhancement layer. The documents EP1076368, EP1439589, EP1443572 and US2007-159087 disclose organic light emitting diodes with such dielectric layers. Such a layer is called "Capping layer" by IBM, "absorption-reduction layer" by Kodak, "outcoupling enhancement layer" by Novaled, "index-matching layer" by HannStar. The thin metal layer and the dielectric layer form together what is called a composite electrode. This composite electrode then comprises a stack of two directly adjacent layers : a thin metal layer and a dielectric layer.

Instead of using, in an OLED, a "single composite" semi-transparent electrode having two overlapping layers comprising a metal layer and a dielectric layer comprising an electrode covered by a dielectric layer, Shih-Feng Hsu, Shiao-Wen Hwang and Chin H. Chen described an OLED having a "double composite" semi-transparent electrode : see the article entitled "White Light Top-emitting Light-emitting Devices" published in 2005 in the proceedings of the International Display Manufacturing Conference 2005 (IDMC '05), p.691. See also, from the same authors, the article entitled "Highly efficient top-emitting white organic electroluminescent devices" published in Applied Physics Letters 86, 253508 (2005). This "double composite" semi-transparent electrode comprises a stack of directly adjacent layers, comprising : a first metal layer made of Ca, a first dielectric layer made of ZnSe, a second metal layer made of Ag and a second dielectric made of Sn02. The OLED disclosed by Shih-Feng Hsu et al. is able to emit white light; therefore, wavelengths of the emitted light is distributed over a range of wavelengths which extends over more than 150 nm.

A problem is that this light-extraction enhancement techniques work generally well only for a limited range of wavelengths, for instance between 490 and 580 nm (taking the 50% attenuation points) when λ_{E}= 535 nm. Therefore, for an OLED having a large range of wavelengths of emission, for instance a range larger than 150 nm, notably for white-emitting organic diodes, this light-extraction enhancement technique does not work well. Consequently, this light-extraction enhancement technique is difficult to apply for OLED, notably white emitting OLED, adapted to emit light the wavelengths of which is distributed on a range of wavelengths larger than 150 nm.

An object of the invention is to propose a light-extraction enhancement layer that is notably adapted to enhance light extraction in a range of wavelengths superior to 150 nm.

For this purpose, the subject of the invention is an organic light emitting diode comprising a bottom electrode, a top electrode, and, between these electrodes, at least one organic electroluminescent layer that is adapted to emit light through one of said electrodes that is semi-transparent when an electric current is injected through this layer by said electrodes, wherein wavelengths of said emitted light are centered on a central wavelength λ_{M}, wherein said semi-transparent electrode comprises, in the order following the direction of light extraction, a first metal layer, a first dielectric layer having a thickness H_{D1} and made of a first dielectric material having an index of refraction n_{D1} at said central wavelength λ_{M}, a second metal layer, and a second dielectric layer having a thickness H_{D2} and made of a second dielectric material having an index of refraction n_{D2} at said central wavelength λ_{M}, said layers being directly adjacent, wherein said thicknesses H_{D1}, H_{D2} meet the following relations : 0.8 x (λ_{M}/8.n_{D2}) < H_{D2} < 2.2 x (λ_{M}/8.n_{D2}) and (λ_{M}/8.n_{D1}) < H_{D1} < 4 x (λ_{M}/8.n_{D1}).
Compared to the prior art as disclosed by Shih-Feng Hsu et al. already quoted, the thickness of the first dielectric layer is higher. Thank to the invention, it has been observed that the light extraction is improved.
The first dielectric material may be different from the second dielectric material, or both dielectric materials may be identical. Their index of refraction will preferably be larger than 1.5, more preferably between 1.7 and 3.
In order to get a semi-transparent electrode, the thickness of the metal layers will preferably be between 3 and 40 nm in case of silver, more preferably between 10 and 30 nm. Metals other than silver may be used, provided they offer a good reflectance and a good transmittance: gold, magnesium, calcium, aluminum can also be used. Alloys can also be used for the metal layers. An example of alloy is based on Ag with 0.1 wt% Pd and 0.1 wt% of Al, as disclosed for instance in the document US2002/140885. Ytterbium was also quoted as being advantageous in conjunction with silver.
Preferably, the wavelengths of said emitted light is distributed over a range of wavelengths which extends over more than 150 nm. The invention is notably well adapted to white emitting OLED, because the composite electrode brings an improvement of the light extraction over a large range of wavelengths.
Preferably, the OLED comprises a plurality of stacked organic light-emitting layers, which may not be directly adjacent, each adapted to emit visible light, and said range of wavelengths encompasses the wavelengths of visible light which can be emitted by each of said organic light-emitting layers.
Preferably, the first dielectric material and second dielectric material is selected in the group consisting of Zr02, LiNb03, SiO, Sn02, PbF2 and Sb2O3. The refraction index of the dielectric materials of this group is around 2.
Preferably, the first dielectric material and second dielectric material is selected in the group consisting of ZnSe, ZnS, SnS, Te02 and Ti02. The refraction index of the dielectric materials of this group is superior or equal to 2.3.
Preferably, said interval between electrodes is an optical cavity. When an interval between a bottom electrode and a top electrode is an optical cavity, it generally imply that :
- one of these electrodes is reflective, preferably made of a metal, and the other one is partially reflective;
- the distance between these two electrodes is a multiple of λ_{M}/2.n_{O}, possibly corrected with the penetration of light inside the electrodes, where no is the optical index of material within this interval.
The subject of the invention is also a lighting or display panel comprising a plurality of organic light emitting diodes according to the invention.

The invention will be more clearly understood on reading the description which follows, given by way of a non-limiting example and with reference to the appended figures in which:
- Figure 1 illustrates an organic light emitting diode according to an embodiment of the invention;
- Figure 2 illustrates the emission spectrum of the diode of figure 1 (solid line) compared to the emission spectrum of a diode of the prior art (o symbols).

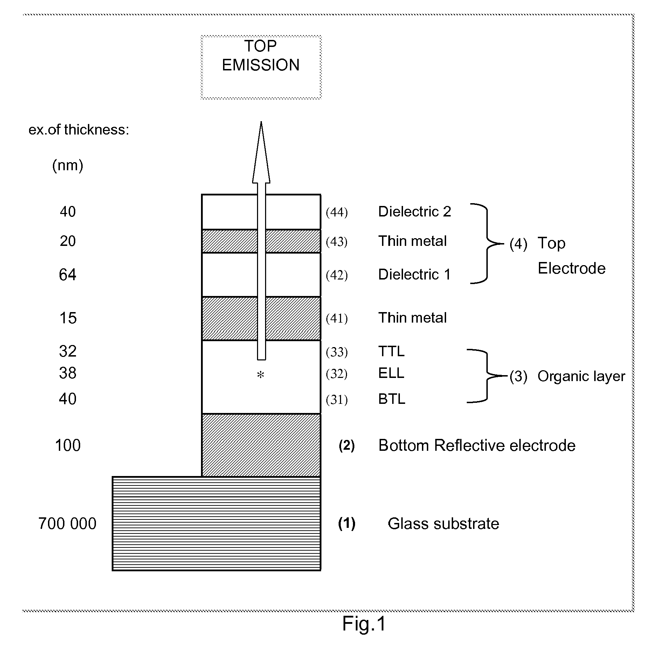

In reference to figure 1, an organic light emitting diode according to an embodiment of the invention comprises :
- a substrate 1, for instance made of glass;
- a bottom electrode 2, for instance made of metal, which is thick enough to be opaque (for instance 100 nm), which is then reflective;
- an organic layer 3 made of a stack of organic sublayers : a Bottom Transport Layer 31 (BTL), an ELectroluminescent Layer 32 (ELL), and a Top Transport Layer 33 (TTL); the electroluminescent layer 32 is doped with optically active dopants that are adapted in a manner known per se to get a white light emission extending in a range of wavelengths larger than 150 nm, for instance from 465 nm to 605 nm, i.e. from the blue up to the red. The center λ_{M} of this range of wavelengths is then 535 nm;
- a top semi-transparent electrode 4, comprising a stack of directly adjacent sublayers : a first metal layer 41, a first dielectric layer 42 having a thickness H_{D1} and made of a first dielectric material having an index of refraction n_{D1} at the central wavelength λ_{M}, a second metal layer 43 and a second dielectric layer 44 having a thickness H_{D2} and made of a second dielectric material having an index of refraction n_{D2} at the central wavelength λ_{M}.

The white vertical arrow on figure 1 represents the direction of light extraction through the semi-transparent electrode 4 according to the invention.

According to the invention, the first and second dielectric materials with their thicknesses H_{D1} and H_{D2} are chosen such that the following relations are met : 0.8 x (λ_{M}/8.n_{D2}) < H_{D2} < 2.2 x (λ_{M}/8.n_{D2}) for the second dielectric layer and (λ_{M}/8.n_{D1}) < H_{D1} < 4 x (λ_{M}/8.n_{D1}) for the first dielectric layer, the second dielectric layer being located further away from the organic layer than the first dielectric layer.

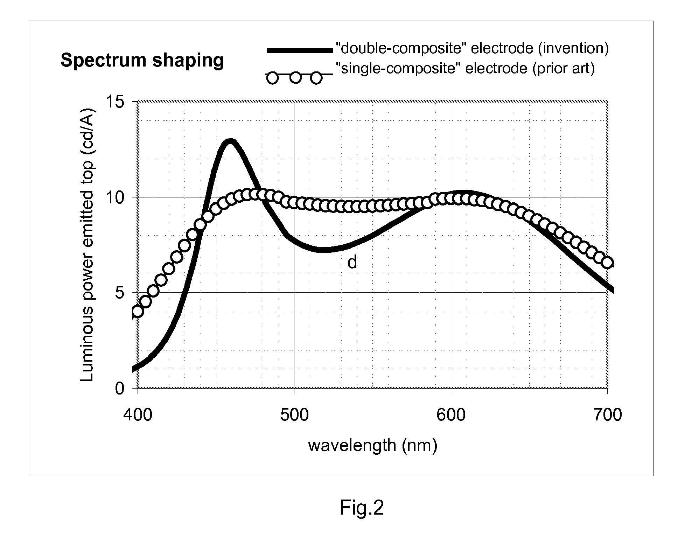

In a more specific example of this embodiment illustrated also on figure 1, the bottom electrode 2 is made of 100 nm Ag; the thickness of the BTL 31 is 40 nm, the thickness of the ELL 32 is 38 nm, the thickness of the TTL 33 is 32 nm ; the first metal layer 41 is made of 15 nm Ag, the first dielectric layer 42 is made of Te02 with n_{D1} = 2.4 and H_{D1} = 64 nm, the second metal layer 43 is made of 20 nm Ag, and the second dielectric layer 44 is made also of Te02 with n_{D2} = n_{D1} = 2.4 and H_{D2} = 40 nm. As λ_{M}/8.n_{D1} = 28 nm, one can see that the above relations according to the invention are met : 0.8 x (λ_{M}/8.n_{D2}) < H_{D2} < 2.2 x (λ_{M}/8.n_{D2}) becomes : 22 nm < H_{D2} = 40 nm < 61 nm and 28 nm < H_{D1} = 64 nm < 111 nm. The spectrum of the OLED that is obtained according to the invention is illustrated on the solid thick line of figure 2. As can be seen on this figure, thank to the invention, the "double composite" semi-transparent electrode 4 is adapted to enhance light extraction in a range of wavelengths larger to 150 nm.

The invention brings also the following advantages :
a) the emission spectrum of OLEDs having a range of wavelengths extending over more than 150 nm can be more finely adjusted. For instance, when considering a white emitting OLED as previously described in reference with figure 1 in which it is desired to amplify the blue and red regions of emission, the best results than can be obtained using a "double composite" semi-transparent electrode according to the invention are illustrated on the solid thick line on figure 2. By comparison, using a "single composite" semi-transparent electrode, the best results that are illustrated on the same figure with the line having the o symbols shows that, notably in the red region, the amplification is far lower compared to the invention;
b) compared to a "single composite" semi-transparent electrode having only one dielectric layer, using two dielectric layers, as in the "double composite" semi-transparent electrode of the invention, gives more numerous degrees of choice (nature and thickness of two dielectric material instead of one) then allowing a better optimization of the light extraction;
c) compared to a "single composite" semi-transparent electrode having only one metal layer, using two metal layers, as in the "double composite" semi-transparent electrode of the invention, allows semi-transparent electrodes with higher electrical conductivities.

Of course, the composite semi-transparent electrode of the invention may be a bottom electrode. Even both electrodes may be semi-transparent.

Example 1 below illustrates the invention. Reference example 1 is presented for comparison with the prior art. Identical references will be used for the layers which provide the same functions.

### Reference example 1 : white bottom-emitting organic diode according to prior art :

A glass substrate 1 received from Asahi Glass (0.7mm glass/155nm ITO polished/230 nm Cr) is first cleaned in de-ionized water then patterned by photolithography (NMP strip); following these steps the active area is a free 3 mm disc of ITO, forming a bottom electrode 2 acting as an anode ; on the inactive area, the ITO is covered by 290 nm of insulating resin (TELR-P003 from Tokyo Ohka Kogyo).

The resin is then hardened by baking at 200°C during 30 minutes, the substrate is cleaned by de-ionized water, and dried at 200°C during 5 minutes, then put under vacuum at 180°C during 20 minutes, before entering the vacuum deposition equipment (Sunicel Plus equipment, base pressure of 70 µPa). The ITO is then subjected to plasma treatment under oxygen during 3 minutes.

A group of stacked organic layers 3 is then deposited. The first organic layer 31 is a doped hole transport layer of 35 nm (a spiro compound doped with 2% F4-TCNQ), deposited at 0.3 nm/s, followed by an electron blocking layer of 10 nm NPB, deposited at 0.1 nm/s. Then an electroluminescent layer 32 was deposited with a thickness of 38 nm (in sequence blue, green and red host+dopant, from ldemitsu and Covion). An hole blocking layer of 2 nm BPhen was then deposited at 0.15 nm/s, followed by an electron transport layer 33 of 25 nm (BPhen doped (1.8%) with a proprietary dopant TND1. The obtained group of stacked organic layers 3 is adapted to emit a white visible light which is distributed in a range of wavelengths extending from 465 nm to 605 nm.

Finally a 120 nm layer of aluminum was deposited as a top electrode 4 acting as cathode (0.15 nm/s).

A glass cover with a recess for a getter was attached in a glove box (N2 atmosphere) to obtain the reference example 1 diode.

This reference diode was then evaluated by subjecting it to a DC current. The following results were then obtained : 6.2 cd/A at 100 cd/m², 6 Im/W, 3.3 % quantum efficiency, 3.88 V at 100 A/m2, and chromaticity coordinates x=0.34 ; y=0.32.

### Example 1 : white top emitting organic diode according to the invention :

The same Asahi substrate 1 as for the reference example 1 above is subjected to the same photolithography steps, except that the TELR resin is not deposited. After cleaning in de-ionized water and drying at 200°C during 5 minutes + vacuum 180°C during 20 minutes, the substrate1 is transferred to the vacuum deposition equipment for deposition of a silver anode on top of the ITO layer. Here, the ITO layer is not necessary but used as a convenient base for its good surface smoothness. The ITO is subjected to plasma treatment under oxygen during 2.5 minutes, then an opaque layer of silver is deposited at 0.15 nm/s up to a thickness of 120 nm.

The silver layer is then subjected to 2 minutes of Ar plasma treatment, removed from the vacuum deposition equipment, and returns to the photolithography area for deposition of the same resin TELR; the active area of the bottom electrode 2 acting as an anode is now a free 3 mm disc of silver; on the inactive area the silver is covered by 290 nm of the insulating resin. After 30 minutes baking, the substrate is transferred again to the vacuum deposition equipment.

A group of stacked organic layers 3 is then deposited. The first organic layer 31 deposited on silver is the same doped hole transport layer as in reference example 1 but has a thickness of 37 nm, followed by the same electron blocking layer of 7 nm NPB. Then exactly the same emitting layer as in reference example 1 was deposited (thickness of 38 nm). The same hole blocking layer of 2 nm BPhen was deposited, followed by the same electron transport layer with a thickness of 28 nm. The obtained group of stacked organic layers 3 is adapted to emit a white visible light that is distributed in a range of wavelengths extending from 465 nm to 605 nm. The center λ_{M} of this range of wavelengths is then 535 nm.

Then a semi-transparent composite cathode 4 was deposited : first, a first metal layer 41 made of 15 nm of silver at 0.1 nm/s, second a first dielectric layer 42 made of H_{D1}= 74 nm of Te02 (Sigma-Aldrich, 99% grade), third a second metal layer 43 made of 16 nm of silver at 0.1 nm/s, fourth a second dielectric layer 44 made of H_{D2}= 46 nm of Te02. The averaged refraction index n_{D1} = n_{D2} of Te02 within the range 465 nm - 605 nm is 2.3, and then λ_{M}/8.n_{D1} = 28 nm. H_{D1} then represents 2.6 in units λ_{M}/8.n_{D1} which is comprised between 1 and 4 according to the invention, and H_{D2} then represents 1.6 in units λ_{M}/8.n_{D1} which is comprised between 0.8 and 2.2 according to the invention.

As above a glass cover with recess was attached in a glove box (N2 atmosphere) to obtain the example 1 diode.

This diode was then evaluated by subjecting it to a DC current. The following results were then obtained : 9.7 cd/A at 100 cd/m², 9.3 Im/W, 5.1 % quantum efficiency, 4.74 V at 100 A/m2, and chromaticity coordinates x=0.435 ; y=0.41.

The comparison of the results obtained for the example 1 diode with results obtained for the reference example 1 diode illustrates, besides the shaping of the spectrum which has already been demonstrated above, the improvement of light extraction for the entire range of emitted wavelength that is provided by the invention.

While the present invention has been described with respect to a particular example, it is understood that the present invention is not limited to this example. The present invention as claimed therefore includes variations from this particular example described herein, as will be apparent to one of skill in the art. While some of the specific embodiments may be described and claimed separately, it is understood that the various features of embodiments described and claimed herein may be used in combination.

## Claims

1. Organic light emitting diode comprising a bottom electrode (2), a top electrode (4), and, between these electrodes (2, 4), at least one organic electroluminescent layer (32) that is adapted to emit light through one (4) of said electrodes that is semi-transparent when an electric current is injected through this layer by said electrodes, wherein wavelengths of said emitted light are centered on a central wavelength λ_{M}, wherein said semi-transparent electrode (4) comprises, in the order following the direction of light extraction, a first metal layer (41), a first dielectric layer (42) having a thickness H_{D1} and made of a first dielectric material having an index of refraction n_{D1} at said central wavelength λ_{M}, a second metal layer (43) and a second dielectric layer (44) having a thickness H_{D2} and made of a second dielectric material having an index of refraction n_{D2} at said central wavelength λ_{M}, **characterized in that** said thicknesses H_{D1}, H_{D2} meet the following relations : 0.8 x (λ_{M}/8.n_{D2}) < H_{D2} < 2.2 x (λ_{M}/8.n_{D2}) and (λ_{M}/8.n_{D1}) < H_{D1} < 4 x (λ_{M}/8.n_{D1}).

2. Organic light emitting diode according to claim 1, **characterized in that** wavelengths of said emitted light is distributed over a range of wavelengths which extends over more than 150 nm.

3. Organic light emitting diode according to claim 2 **characterized in that** it comprises a plurality of stacked organic light-emitting layers, each adapted to emit visible light, wherein said range of wavelengths encompasses the wavelengths of visible light which can be emitted by each of said organic light-emitting layers.

4. Organic light emitting diode according to any one of claims 1 to 3, **characterized in that** at least one of the first dielectric material and second dielectric material is selected in the group consisting of Zr02, LiNb03, SiO, Sn02, PbF2 and Sb203.

5. Organic light emitting diode according to any one of claims 1 to 3, **characterized in that** at least one of the first dielectric material and second
